# EUROPÄISCHE PATENTSCHRIFT

(11) **EP 1 722 005 B1**
(45) Veröffentlichungstag und Bekanntmachung des Hinweises auf die Patenterteilung: **04.07.2007**
(21) Anmeldenummer: 05010419.9
(22) Anmeldetag: 13.05.2005
(51) Int. Cl.: C23C 14/35

(54) **Verfahren zum Betreiben einer Sputterkathode mit einem Target**
Method of using a sputtering cathode together with a target
Méthode pour l'utilisation d'une cathode de pulvérisation ayant une cible

(43) Veröffentlichungstag der Anmeldung: 15.11.2006
(73) Patentinhaber: Applied Materials GmbH & Co. KG, 63755 Alzenau (DE)
(72) Erfinder: Bangert,Stefan, 36396 Steinau (DE); Hanika, Markus, 86899 Landsberg (DE); König, Michael, 60529 Frankfurt am Main (DE)
(74) Vertreter: Schickedanz, Willi

(56) Entgegenhaltungen:
- EP-A- 0 703 599
- WO-A-82/02725
- US-B1- 6 303 008
- WRIGHT M ET AL: "Design advances and applications of the rotatable cylindrical magnetron" JOURNAL OF VACUUM SCIENCE AND TECHNOLOGY: PART A, AMERICAN INSTITUTE OF PHYSICS. NEW YORK, US, Bd. 4, Nr. 3, 1986, Seiten 388-392, XP002314779 ISSN: 0734-2101

## Beschreibung

Die Erfindung betrifft ein Verfahren nach dem Oberbegriff des Patentanspruchs 1.

Materialschichten, die auf einem Substrat - beispielsweise einer Kunststofffolie oder Glas - aufgebracht werden sollen, werden häufig mittels des so genannten Sputterprozesses aufgebracht. Dieser Sputterprozess läuft in einer Vakuumkammer ab, in der sich ein Plasma befindet.

Hierbei werden Teilchen mittels der im Plasma befindlichen Ionen aus einem Target herausgeschlagen, die sich dann auf einem dem Target gegenüber liegenden Substrat niederschlagen.

Das Target ist mit einer Kathode verbunden, an der eine negative Spannung anliegt, welche positive Ionen aus dem Plasma beschleunigt.

Um möglichst viele Teilchen aus einem Target herauszuschlagen, werden in der Nähe dieses Targets Magnete eingesetzt, deren Magnetfeld das Target durchdringt. Hierdurch werden die Elektronen, welche für die Ionisierung des Plasmas verantwortlich sind, in der Nähe der Oberfläche des Targets gebündelt. Die Kombination aus Kathode und Dauermagneten wird auch Magnetron genannt.

Sind Kathode und Target eben, so spricht man von einem Planarmagnetron.

Seit einiger Zeit werden jedoch in verstärktem Maß hohlzylindrische Magnetrons wegen ihrer großen Targetmaterialausbeute eingesetzt. Diese Magnetrons werden bisweilen auch Rohrkathoden genannt.

Auf der Außenseite einer rohrförmigen Kathode befindet sich ein ebenfalls rohrförmiges Target. Das rohrförmige Target rotiert um die Kathodenlängsachse, wobei in der Kathode Magnete ortsfest angeordnet sind. Das Magnetfeld dieser Magnete durchdringt Kathode und Target und befindet sich somit auch im Plasma.

Unter "Rohrkathode" werden oft auch ganze Einheiten verstanden, die einen Motor, eine Drehdurchführung, Lagerungen, elektrische Schleifer, Kühlmittelleitungen und ein Magnetsystem umfassen, wobei das Magnetsystem zusammen mit einem Teil der Targetkühlung in dem zylinderförmigen Target angeordnet ist.

Es ist bereits eine Sputtervorrichtung mit einer Magnetronkathode mit rotierendem Target bekannt, wobei das Target auf besondere Weise gekühlt wird (DE 41 17 368 A1).

Bei einer anderen bekannten rotierenden Magnetronkathode sind an zwei einander gegenüber liegenden Stellen der Kathode Magnete vorgesehen, sodass zwei Substrate gleichzeitig mit einer Sputterschicht versehen werden können (DE 41 26 236 A1).

Schließlich ist auch noch eine Drehkathode für die Kathodenzerstäubung bekannt, welche ein rohrförmiges Bauteil, das sich um seine Achse drehen kann und auf seinem Umfang mindestens ein zu zerstäubendes Material trägt (EP 0 703 599 B1). Diese Drehkathode enthält auch noch ein Magnetsystem sowie mechanische Mittel, die während der Zerstäubung eine schwingende Drehbewegung des rohrförmigen Bauteils ermöglichen. Hierdurch soll die Aufgabe gelöst werden, ein Verfahren zum schnellen Wechseln des Targetmaterials einer Kathode für die magnetrongestützte Kathodenzerstäubung bereitzustellen. Um bei einer Anordnung mit zwei rotierenden verschiedenen Targets, die jeweils halbzylindrisch ausgebildet sind, einen gleichmäßigen Abtrag zu erzielen, lässt man die Drehkathode während des Abscheidens mit einer Amplitude schwingen, die kleiner oder gleich α/2 ist. Bei zwei verschiedenen Targets beträgt α = 180°.

Der Erfindung liegt die Aufgabe zugrunde, bei einer Sputterkathode mit einem Target, das durch ein Magnetfeld hindurch bewegt wird, den negativen Einfluss des Induktionsstroms auf die Beschichtungsqualität zu eliminieren.

Diese Aufgabe wird gemäß den Merkmalen des Anspruchs 1 gelöst.

Die Erfindung betrifft somit ein Verfahren zum Betreiben einer Magnetron-Sputterkathode, insbesondere einer Rohrkathode bzw. mehrerer ein Array bildenden Rohrkathoden. Bei solchen Kathoden durchläuft ein Target ein Magnetfeld, wodurch Induktionsströme in dem Target fließen, die das Magnetfeld verzerren. Hierdurch entsteht eine ungleiche Beschichtung eines Substrats. Indem die Relativbewegung zwischen dem Magnetfeld und dem Target ihre Richtung abwechselnd umkehrt, kann der Effekt der Magnetfeldverzerrung kompensiert werden. Hierdurch erhält man eine größere Gleichmäßigkeit der Beschichtung auf einem zu beschichtenden Substrat.

Der mit der Erfindung erzielte Vorteil besteht insbesondere darin, dass die bei einer kontinuierlich in einer Richtung sich drehenden Rohrkathode oder Rohrkathodenanordnung mit leitfähigem Targetmaterial auftretenden Deformationen der Schichtdickenverteilung vermieden werden.

Ausführungsbeispiele der Erfindung sind in den Zeichnungen dargestellt und werden im Folgenden näher beschrieben. Es zeigen:
- Fig. 1: mehrere parallel zueinander angeordnete Rohrkathoden in einer Sputterkammer;
- Fig. 2: die Schichtdickenverteilung auf einem Substrat bei einem statischen Betrieb einer Sputteranlage mit mehreren Rohrkathoden;
- Fig. 3: die Schichtdickenverteilung auf einem Substrat bei dynamischem Betrieb einer Sputteranlage mit mehreren Kathoden, wobei sich die Kathoden in einer ersten Richtung drehen;
- Fig. 4: die Schichtdickenverteilung auf einem Substrat bei dynamischem Betrieb einer Sputteranlage mit mehreren Kathoden, wobei sich die Kathoden in einer zweiten Richtung drehen;
- Fig. 5: einen Querschnitt durch eine Rohrkathode;
- Fig. 6: einen Längsschnitt durch eine Plasmakammer.

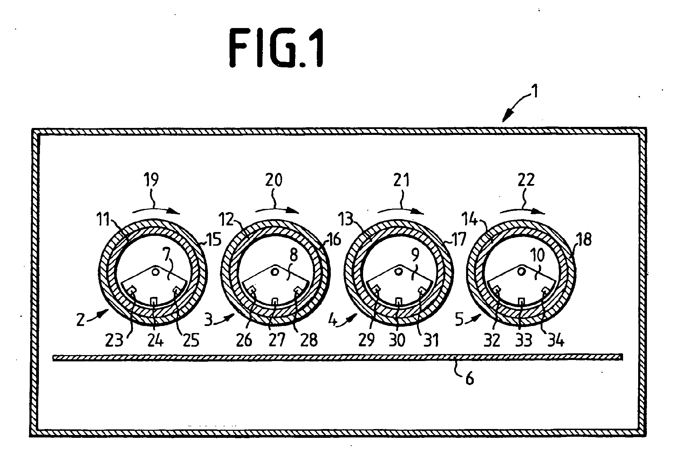

In der Fig. 1 ist ein Schnitt durch eine Vakuumkammer 1 dargestellt, in der sich vier drehbare Rohrkathoden 2 bis 5 befinden. Gegenüber diesen Rohrkathoden 2 bis 5 befindet sich ein zu beschichtendes Substrat 6, beispielsweise eine Glasscheibe.

Jede der Rohrkathoden 2 bis 5 weist ein kreisbogenförmiges Magnetjoch 7 bis 10 sowie ein tragendes Rohr 11 bis 14 auf, auf dessen Außenseite sich ein zylindrisches Target 15 bis 18 befindet.

Die Rohre 11 bis 14 mit den zugehörigen Targets 15 bis 18 drehen sich bei der Darstellung der Fig. 1 in Richtung der Pfeile 19 bis 22, also im Uhrzeigersinn. Sie können sich jedoch auch im Gegenuhrzeigersinn drehen.

In den kreisbogenförmigen Magnetjochen 7 bis 10 sind jeweils drei Dauermagnetreihen 23 bis 34 angeordnet, von denen die Dauermagnetreihen 23, 25; 26, 28; 29, 31 und 32, 34 die gleiche Polarität haben, während die sich zwischen ihnen befindlichen Dauermagnetreihen 24, 27 bzw. 30, 33 eine entgegengesetzte Polarität besitzen. Die Magnetjoche 7 bis 10 mit den Dauermagnetreihen 23 bis 34 sind ortsfest angeordnet, d. h. sie drehen sich nicht mit den Rohren 11 bis 14 und den Targets 15 bis 18.

Werden die Targets 15 bis 18 bei einer Anordnung gemäß Fig. 1 gesputtert, so lagert sich auf der Oberfläche des Substrats eine Beschichtung ab, die aus dem gleichen Material besteht wie das Target. Beim reaktiven Sputtern kann das vom Target abgesputterte Material vor dem Niederschlag auf dem Substrat auch noch eine chemische Verbindung eingehen. Da die Rohrkathoden 2 bis 5 nicht unendlich dicht gepackt werden können, haben sie einen Abstand voneinander, was eine inhomogene Beschichtung senkrecht zu den in die Zeichenebene hineinragenden Längsachsen der Rohrkathoden 2 bis 5 bewirkt.

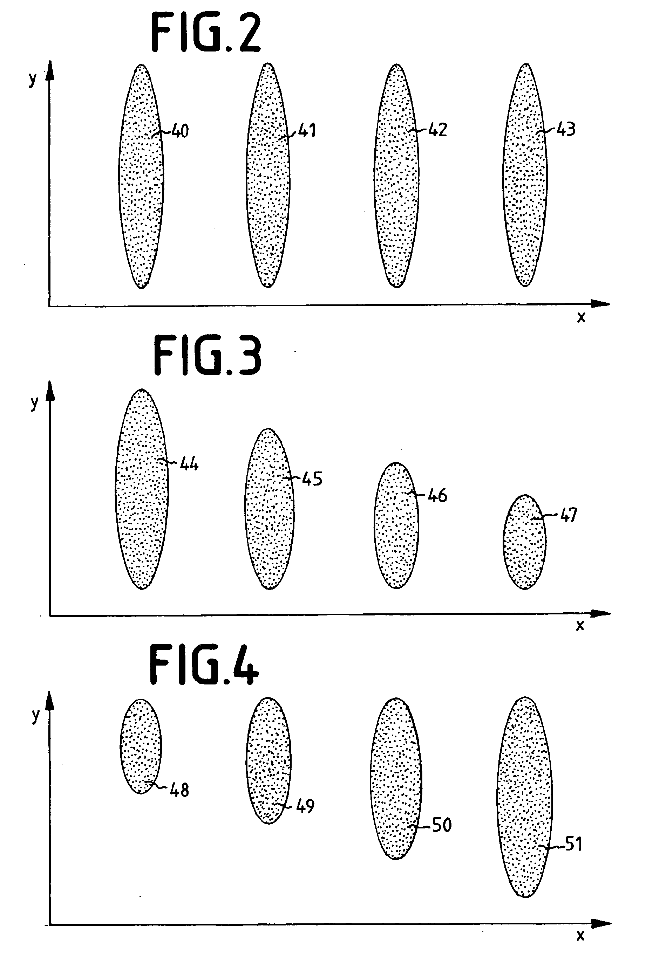

In der Fig. 2 ist dargestellt, wie die Widerstandsverteilung einer metallischen Beschichtung verläuft, wenn sich die Rohrkathoden 2 bis 5 nicht drehen, d. h. wenn im statischen Zustand gesputtert wird. Die Drehachsen der Rohrkathoden 2 bis 5 sind in y-Richtung ausgerichtet. Diese y-Richtung ist die Richtung in die Zeichenebene der Fig. 1 hinein. Die x-Richtung bezeichnet die horizontale Richtung in Fig. 1. Die Ellipsen 40 bis 43 bezeichnen die Bereiche hohen elektrischen Widerstands, d. h. geringer Schichtdicke auf dem Substrat. Sie liegen direkt unter den einzelnen Rohrkathoden 2 bis 5 auf dem Substrat. Die Hauptachsen der Ellipsen 40 bis 43 verlaufen somit unterhalb der Drehachsen der Rohrkathoden 2 bis 5 und bezeichnen Bereiche hohen elektrischen Widerstands. Da direkt unterhalb der Rohrkathoden die Magnetfelder schwächer als in den Randbereichen der Rohrkathoden sind, schlägt sich dort auch weniger Sputtermaterial nieder. Direkt unter den Rohrkathoden findet aber ein geringerer Niederschlag des Targetmaterials statt, was sich in einer geringeren Schichtdicke und damit in einem erhöhten elektrischen Widerstand widerspiegelt. Die Ellipsen 40 bis 43 zeigen die Bereiche erhöhten elektrischen Widerstands an; sie sind in der Praxis relativ schmal ausgebildet.

Fig. 3 zeigt die Widerstandsverteilungen des auf dem Substrat 6 aufgesputterten Materials, wenn sich die Rohrkathoden 2 bis 5 alle im Uhrzeigersinn drehen, also in Richtung der Pfeile 19 bis 22.

Man erkennt hierbei, dass die Verteilung der Bereiche des erhöhten Widerstands entlang der Drehachsen der einzelnen Rohrkathoden 2 bis 5 nicht mehr gleichmäßig ist, d. h. die Ellipsen werden mit zunehmendem x-Abstand immer kleiner. Der beobachtete Effekt der Ellipsenlängenänderung tritt auch bei Einzelkathoden auf, doch macht er sich erst bei Kathodenarrays mit mehreren Kathoden deutlich bemerkbar. Der Mechanismus für die Zunahme der Verschiebung der Bereiche mit geringer Beschichtung und damit hohem elektrischen Widerstand in y-Richtung, ist nicht vollständig bekannt. Möglicherweise wird durch die überlappenden Plasmazonen eine Störung von Kathode zu Kathode übertragen, sodass sich der Effekt verstärkt.

In der Fig. 4 ist die Verteilung des erhöhten Widerstands für den Fall dargestellt, dass die Rohrkathoden 2 bis 5 gegen den Uhrzeigersinn rotieren. Auch hier ist die Verteilung des erhöhten Widerstands des gesputterten Materials auf dem Substrat 6 nicht gleichmäßig, aber im umgekehrten Sinn, d. h. die Ellipsen werden mit zunehmendem Abstand x immer größer.

Es fällt auf, dass die Unsymmetrien der Bereiche geringen Niederschlags beim Rotieren im Uhrzeigersinn einerseits und im Gegenuhrzeigersinn andererseits gegenläufig sind. Beim Rotieren im Uhrzeigersinn (Fig. 3) werden die Hauptachsen der Ellipsen 44 bis 47 in x-Richtung kleiner, während die Hauptachsen der Ellipsen 48 bis 51 beim Rotieren im Gegenuhrzeigersinn in x-Richtung größer werden.

Rotieren die Rohrkathoden 2 bis 5 für eine Zeit t₁ und mit einer vorgegebenen Geschwindigkeit im Uhrzeigersinn und anschließend für die gleiche Zeit t₁ und bei gleicher Geschwindigkeit im Gegenuhrzeigersinn, so erhält man wieder die in der Fig. 2 dargestellte Verteilung, d. h. eine Verteilung wie beim statischen Sputtern. Es gleichen sich gewissermaßen zwei gegenläufige Fehler aus. Um eine optimale Gleichmäßigkeit der Beschichtung auf dem Substrat zu erhalten, müssen sich allerdings nicht immer alle Kathoden mit exakt derselben Umfangsgeschwindigkeit und in dieselbe Richtung drehen. Vielmehr können die Umfangsgeschwindigkeiten und die Umlaufzeiten variieren. Dies gilt insbesondere dann, wenn die einzelnen Kathoden Fertigungstoleranzen aufweisen. In diesem Fall sollten die Umlaufgeschwindigkeiten etc. an die jeweiligen Kathoden angepasst werden.

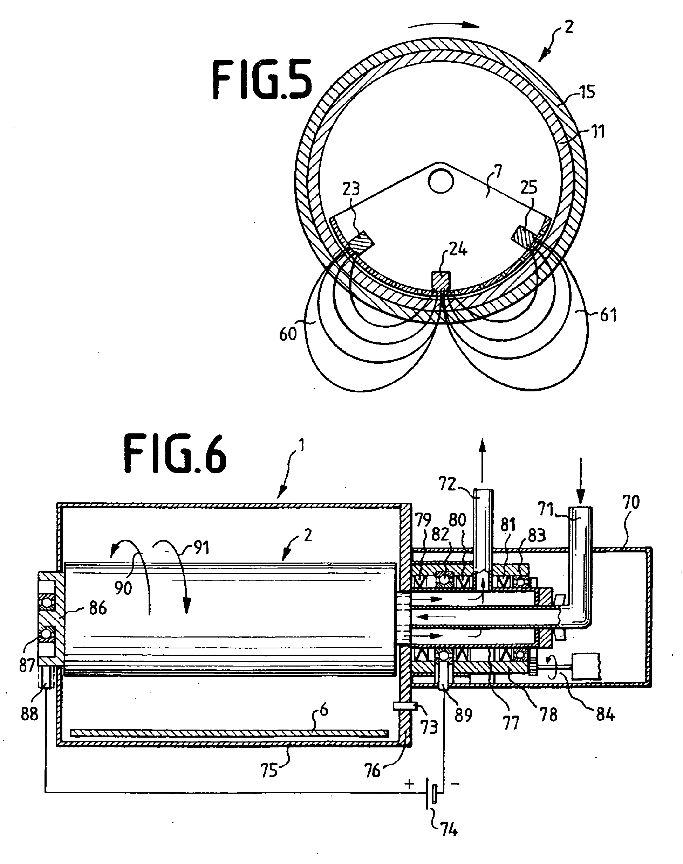

In der Fig. 5 ist die Rohrkathode 2 der Fig. 1 noch einmal vergrößert dargestellt. Bei dieser Darstellung sind die Feldlinien 60, 61 des durch die Dauermagnete 23 bis 25 aufgebauten Magnetfelds gezeigt.

Man erkennt hierbei, dass die Feldlinien symmetrisch zur Rohrkathode 11 und zum Target 15 verlaufen und dass die magnetische Feldstärke direkt unter der Rohrkathode schwächer ist als seitlich hiervon.

Diese symmetrische Ausrichtung der Feldlinien gilt für den statischen Betrieb, d. h. wenn sich die Rohrkathode 2 nicht um die ortsfesten Dauermagnete 23 bis 25 dreht. Dreht sich die Rohrkathode 2 jedoch um diese Dauermagnete 23 bis 25, so werden die Feldlinien der Dauermagnete 23 bis 25 durch das Target 15 geschnitten. Die in einem elektrisch leitenden Target befindlichen Elektronen erfahren hierdurch Kräfte senkrecht zur Bewegungsrichtung des Targets 15 und zur Feldlinienrichtung, d. h. senkrecht zur Zeichenebene. Hierdurch tritt in dieser Richtung eine Spannung U bzw. elektrische Feldstärke E im Target auf, weil die Elektronen entlang der Längsachse des Targets 15 ungleichmäßig verteilt sind. Die elektrische Feldstärke E errechnet sich hierbei mittels der Gleichung Eᵢ = v x B, wenn Eᵢ die induzierte elektrische Feldstärke, v die Umfangsgeschwindigkeit des Targets und B die magnetische Feldstärke der Dauermagnete 23 bis 25 ist. Dadurch ergibt sich ein induzierter Strom, der seinerseits ein Magnetfeld aufbaut, das sich dem vorhandenen Magnetfeld der Dauermagnete 23 bis 25 überlagert. Hierdurch wird das resultierende Magnetfeld verzerrt, was die in den Fig. 3 und 4 gezeigten Unsymmetrien zur Folge hat.

Die Deformation der Schichtdickenverteilung erfolgt sowohl in Längsrichtung der Kathode als auch senkrecht hierzu.

Die in der Fig. 5 gezeigten Magnetfelder werden durch die überlagerten Magnetfelder zu einer Seite weggekippt, und zwar bei Rechtsdrehung in die eine und bei Linksdrehung in die entgegen gesetzte Richtung. Durch gleich lange Änderungen in der Drehrichtung kann der bei einer Drehrichtung auftretende Fehler durch den entgegen gesetzten Fehler, der bei Drehung in der entgegengesetzten Richtung auftritt, kompensiert werden. Entsprechend kann durch definierte Zeitenverhältnisse der Drehrichtungen die Verteilung gezielt entlang der y-Richtung verschoben werden.

Durch die im Target induzierten Ströme entstehen auch starke Kräfte zwischen dem Target und den Dauermagneten 23, 24, 25 die der Drehrichtung des Targets entgegengerichtet sind. Der hier anhand von drehenden Rohrkathoden beschriebene Effekt tritt auch bei einem dynamischen Betrieb von Planarkathoden in entsprechender Weise auf, wenn zwischen Target und Magnetfeld eine Relativbewegung stattfindet.

In der Fig. 6 ist ein Längsschnitt durch die Kammer 1 mit der Rohrkathode 2 gezeigt. Die Rohrkathode 2 kann von einem in einem Stutzen 70 befindlichen Antrieb in eine Drehbewegung versetzt werden. An diesem Stutzen 70 sind auch noch ein Fluid-Zufluss 71 und ein Fluid-Abfluss 72 vorgesehen. Unterhalb der Rohrkathode 2 befindet sich das zu beschichtende Substrat 6. Mit 73 ist ein Gaszufluss bezeichnet, dem auf der gegenüber liegenden Seite der Vakuumkammer 1 ein nicht dargestellter Gasabfluss gegenüber liegt.

Die Rohrkathode 2 liegt am negativen Pol einer Spannungsquelle 74, die hier als Gleichspannungsquelle dargestellt ist. Der positive Pol der Spannungsquelle 74 ist mit dem Boden 75 der Vakuumkammer 1 verbunden. Eine Rezipientenwand 76 trennt das in der Vakuumkammer 1 herrschende Vakuum von der Atmosphäre, die den Stutzen 70 umgibt. In dem Stutzen 70 befindet sich ein Fluid-Rohr 77, das den Fluid-Zufluss 71 und den Fluid-Abfluss 72 umfasst. Koaxial um das Fluid-Rohr 77 herum befindet sich ein Rohr 78 aus einem elektrisch nicht leitenden Material. Zwischen den beiden Rohren 77 und 78 sind die Dichtungsringe 79, 80, 81 und zwei Lagerungen 82, 83 angeordnet. Vor der Lagerung 83 befindet sich ein Drehantrieb 84, der die Rohrkathode 2 dreht. Am anderen Ende der Rohrkathode 2 ruht ein Stutzen 86 dieser Rohrkathode 2 in einem Lager 87. Mit 88, 89 sind die Stromzuführungen bezeichnet, an denen die Pole der Gleichspannungsquelle 74 liegen.

Obgleich die Fig. 6 nur eine Rohrkathode 2 zeigt, befinden sich in der Vakuumkammer 1 mehrere Rohrkathoden senkrecht zur Zeichenebene. Diese Rohrkathoden können mit jeweils einem eigenen Antrieb versehen sein. Es ist jedoch auch möglich, einen Antrieb für mehrere Rohrkathoden zu verwenden.

Bei einer Ausführungsform kann der Drehantrieb 84 für eine Drehung im Uhrzeigersinn gemäß Pfeil 90 sowie für eine Drehung im Gegenuhrzeigersinn gemäß Pfeil 91 vorgesehen sein.

Die Drehung einer Rohrkathode 11 in eine Richtung beträgt wenigstens 360°, damit alle Bereiche des Targets 15 zum Sputtern ausgenutzt werden. Es können jedoch auch mehrere Umdrehungen im Uhrzeigersinn und dann die gleiche Anzahl von Umdrehungen im Gegenuhrzeigersinn erfolgen. Allerdings muss die Anzahl der Umdrehungen in beiden Richtungen nicht immer gleich sein.

Die Drehgeschwindigkeit bzw. Winkelgeschwindigkeit der Rohrkathode ist in der Regel konstant. Es ist jedoch prinzipiell auch möglich, die Winkelgeschwindigkeit zu ändern. Der Effekt der Verzerrung des Magnetfelds 60, 61 ist umso größer, je höher die Drehgeschwindigkeit ist.

Wird die Rohrkathode 11 mit einer hohen Geschwindigkeit n-mal im Uhrzeigersinn gedreht, so kann der entstehende Verzerrungs-Fehler bei einer niedrigen Geschwindigkeit im Gegenuhrzeigersinn mit m Umdrehungen kompensiert werden, wobei m > n.

Bei Verwendung mehrerer Rohrkathoden, die ein so genanntes Kathoden-Array bilden, können auch die Winkelgeschwindigkeiten von Rohrkathode zu Rohrkathode variieren.

In der Fig. 6 liegt eine Einzelkathode an einer Gleichspannung. Es kann jedoch ein Kathodenpärchen eingesetzt werden, bei dem es sich um zwei gleichartige Kathoden handelt, die an Wechselspannung gelegt sind. Hierbei arbeiten die Kathoden abwechselnd als Anode und als Kathode.

Die Erfindung kann auch bei Kathodenarrays mit statischer Beschichtung zum Einsatz kommen. Unter statischer Beschichtung wird dabei eine Beschichtung verstanden, bei welcher das Substrat während der Beschichtung ruht und sich nicht relativ zur Kathode bewegt. Das Magnetsystem kann hierbei während der Beschichtung relativ zum Target bewegt werden oder auch nicht.

## Patentansprüche

1. Verfahren zum Betreiben einer Sputterkathode (11), die ein Target (15) aufweist, wobei Sputterkathode (11) und Target (15) relativ zu einem Magnetfeld (60, 61) und durch dieses Magnetfeld (60, 61) hindurch bewegt werden, wobei die Sputterkathode (11) mit dem Target (15) in eine erste Richtung und hierauf in eine zur ersten Richtung entgegengesetzte Richtung bewegt wird, **dadurch gekennzeichnet, dass** mehrere Sputterkathoden (11 - 14) mit ihrem Target (15 - 18) nebeneinander angeordnet sind und dass es sich bei den Targets (15 - 18) um elektrisch leitende Targets (15 - 18) handelt.

2. Verfahren nach Anspruch 1, **dadurch gekennzeichnet, dass** die Sputterkathoden und die Targets planar ausgebildet sind.

3. Verfahren nach Anspruch 1, **dadurch gekennzeichnet, dass** die Sputterkathoden (11 - 14) Rohrkathoden sind und zusammen mit ihren jeweiligen rohrförmigen Targets (15 - 18) mit einer Winkelgeschwindigkeit um wenigstens 360° in die erste Richtung und hierauf mit einer Winkelgeschwindigkeit um wenigstens 360° in eine Richtung gedreht werden, die der ersten Richtung entgegengesetzt ist.

4. Verfahren nach Anspruch 3, **dadurch gekennzeichnet, dass** die Winkelgeschwindigkeit während einer Drehung um wenigstens 360° konstant ist.

5. Verfahren nach Anspruch 3, **dadurch gekennzeichnet, dass** die Winkelgeschwindigkeit während einer Drehung um wenigstens 360° variiert.

6. Verfahren nach Anspruch 3, **dadurch gekennzeichnet, dass** die Targets (15 - 18) n-mal um 360° gedreht werden, wobei n eine ganze Zahl ist und n > 1 gilt.

7. Verfahren nach Anspruch 3, **dadurch gekennzeichnet, dass** die Längsachsen der Rohrkathoden (2 - 5) parallel zueinander ausgerichtet sind.

8. Verfahren nach Anspruch 3, **dadurch gekennzeichnet, dass** die Winkelgeschwindigkeiten aller Rohrkathoden (11 - 14) gleich sind.

9. Verfahren nach Anspruch 3, **dadurch gekennzeichnet, dass** die Winkelgeschwindigkeiten wenigstens zweier Rohrkathoden ungleich sind.

10. Verfahren nach einem oder mehreren der vorangegangenen Ansprüche, **dadurch gekennzeichnet, dass** in einem Abstand von den Targets (15 - 18) ein Substrat (6) angeordnet wird.

11. Verfahren nach Anspruch 7, **dadurch gekennzeichnet, dass** parallel zu den Längsachsen der Rohrkathoden (2 - 5) ein Substrat (6) angeordnet ist.

12. Verfahren nach den Ansprüchen 7 oder 11, **dadurch gekennzeichnet, dass** die Längsachsen der Rohrkathoden (2 - 5) Drehachsen und in einer gemeinsamen Ebene angeordnet sind.

13. Verfahren nach Anspruch 3, **dadurch gekennzeichnet, dass** alle Rohrkathoden (11 - 14) Targets (15 - 18) aufweisen, die aus dem gleichen Material bestehen.

14. Verfahren nach Anspruch 1, **dadurch gekennzeichnet, dass** die Zeiten t₁ für die Bewegung in die erste Richtung und t₂ für die Bewegung in die zweite Richtung der Relativbewegungen gleich sind.

15. Verfahren nach Anspruch 1, **dadurch gekennzeichnet, dass** die Zeiten t₁ für die Bewegung in die erste Richtung und t₂ für die Bewegung in die zweite Richtung der Relativbewegungen ungleich sind.

## Claims

1. Method for operating a sputter cathode (11) having a target (15), in which sputter cathode (11) and target (15) are moved relative to a magnetic field (60, 61) and through this magnetic field (60, 61), whereby the sputter cathode (11) with the target (15) is moved in a first direction and thereupon in a direction opposite to the first direction, **characterized in that** a plurality of sputter cathodes (11-14) with their respective target (15-18) are arranged side by side and that the targets (15-18) are electrically conductive targets (15-18).

2. Method as claimed in claim 1, **characterized in that** the sputter cathodes and the targets are implemented to be planar.

3. Method as claimed in claim 1, **characterized in that** the sputter cathodes (11-14) are tube cathodes and, together with their respective tubular targets (15-18) are rotated at an angular speed for about at least 360° in the first direction and thereupon at an angular speed for about at least 360° in a direction opposite to the first direction.

4. Method as claimed in claim 3, **characterized in that** the angular speed during one rotation about at least 360° is constant.

5. Method as claimed in claim 3, **characterized in that** the angular speed during one rotation about at least 360° is varied.

6. Method as claimed in claim 3, **characterized in that** the targets (15-18) are rotated n times about 360°, where n is an integer and n > 1 applies.

7. Method as claimed in claim 3, **characterized in that** the longitudinal axes of the tube cathodes (2-5) are oriented in parallel.

8. Method as claimed in claim 3, **characterized in that** the angular speeds of all tube cathodes (11-14) are equal.

9. Method as claimed in claim 3, **characterized in that** the angular speeds of at least two tube cathodes are not equal.

10. Method as claimed in one or several of the preceding claims, **characterized in that** a substrate (6) is disposed at a distance from the targets (15-18).

11. Method as claimed in claim 7, **characterized in that** parallel to the longitudinal axes of the tube cathodes (2-5) is disposed a substrate (6).

12. Method as claimed in one of claims 7 or 11, **characterized in that** the longitudinal axes of the tube cathodes (2-5) are rotational axes and disposed in a common plane.

13. Method as claimed in claim 3, **characterized in that** all tube cathodes (11-14) have targets (15-18) comprised of the same material.

14. Method as claimed in claim 1, **characterized in that** the times t₁ for the movement in the first direction and t₂ for the movement in the second direction of the relative movements are equal.

15. Method as claimed in claim 1, **characterized in that** the times t₁ for the movement in the first direction and t₂ for the movemvent in the second direction of the relative movements are not equal.

## Revendications

1. Méthode pour l'utilisation d'une cathode de pulvérisation (11) ayant une cible (15), la cathode de pulvérisation (11) et la cible (15) étant déplacées de manière relative par rapport à un champ magnétique (60, 61) et à travers ce champ magnétique (60, 61), la cathode de pulvérisation (11) étant déplacée avec la cible (15) dans une première direction, puis dans une direction opposée à la première direction, **caractérisée en ce que** plusieurs cathodes de pulvérisation (11 - 14) avec leurs cibles (15-18) sont disposées côte à côte et **en ce que** les cibles (15-18) sont des cibles (15-18) conductrices de l'électricité.

2. Méthode selon la revendication 1, **caractérisée en ce que** les cathodes de pulvérisation et les cibles sont formées de manière planaire.

3. Méthode selon la revendication 1, **caractérisée en ce que** les cathodes de pulvérisation (11-14) sont des cathodes tubulaires et **en ce qu'**elles sont tournées, conjointement avec leurs cibles tubulaires (15 -18) respectives, avec une vitesse angulaire, d'au moins 360° dans une première direction, puis, avec une vitesse angulaire, d'au moins 360° dans une direction opposée à la première direction.

4. Méthode selon la revendication 3, **caractérisée en ce que** la vitesse angulaire est constante pendant une rotation d'au moins 360°.

5. Méthode selon la revendication 3, **caractérisée en ce que** la vitesse angulaire varie pendant une rotation d'au moins 360°.

6. Méthode selon la revendication 3, **caractérisée en ce que** les cibles (15-18) sont tournées n fois de 360°, n étant un nombre entier et n > 1.

7. Méthode selon la revendication 3, **caractérisée en ce que** les axes longitudinaux des cathodes tubulaires (2 - 5) sont alignés de manière parallèle entre eux.

8. Méthode selon la revendication 3, **caractérisée en ce que** les vitesses angulaires de toutes les cathodes tubulaires (11-15) sont égales.

9. Méthode selon la revendication 3, **caractérisée en ce que** les vitesses angulaires d'au moins deux cathodes tubulaires sont inégales.

10. Méthode selon une ou plusieurs des revendications précédentes, **caractérisée en ce qu'**un substrat (6) est disposé à une distance des cibles (15 -18).

11. Méthode selon la revendication 7, **caractérisée en ce qu'**un substrat (6) est disposé parallèlement aux axes longitudinaux des cathodes tubulaires (2 - 5).

12. Méthode selon la revendication 7 ou 11, **caractérisée en ce que** les axes longitudinaux des cathodes tubulaires (2 - 5) sont des axes de rotation et sont disposés dans un plan commun.

13. Méthode selon la revendication 3, **caractérisée en ce que** toutes les cathodes tubulaires (11 - 14) ont des cibles (15-18) réalisées dans la même matière.

14. Méthode selon la revendication 1, **caractérisée en ce que** les temps t₁ pour le déplacement dans la première direction et t₂ pour le déplacement dans la seconde direction des mouvements relatifs sont égaux.

15. Méthode selon la revendication 1, **caractérisée en ce que** les temps t₁ pour le déplacement dans la première direction et t₂ pour le déplacement dans la seconde direction des mouvements relatifs sont inégaux.
